# FASCICULE DE BREVET EUROPEEN

(11) **EP 4 434 300 B1**
(45) Date de publication et mention de la délivrance du brevet: **27.08.2025**
(21) Numéro de dépôt: 22822622.1
(22) Date de dépôt: 14.11.2022
(51) Int. Cl.: H05K 7/14, H05K 3/30, H01R 13/645, H02M 7/00

(54) **ONDULEUR COMPORTANT UN DISPOSITIF D'ALIGNEMENT RELATIF DE TROIS COMPOSANTS**
WECHSELRICHTER MIT EINER VORRICHTUNG ZUR GEGENSEITIGEN AUSRICHTUNG VON DREI KOMPONENTEN
INVERTER COMPRISING A DEVICE FOR THE MUTUAL ALIGNMENT OF THREE COMPONENTS

(30) Priorité: 17.11.2021 FR 2112148
(43) Date de publication de la demande: 25.09.2024
(73) Titulaire: Nidec PSA Emotors, 78955 Carrieres sous Poissy (FR)
(72) Inventeur: MUSSEAU, Nicolas, 03410 Prémilhat (FR); TARDY, Guillaume, 78170 La Celle-Saint-Cloud (FR); BLONDEL, Gael, 77240 Seine-Port (FR); DELAIRE, Quentin, 92310 Sèvres (FR)
(74) Mandataire: VATD
(86) Numéro de dépôt international: PCT/FR2022/000106
(87) Numéro de publication internationale: WO 2023/089249

(56) Documents cités:
- EP-A1- 2 736 160
- EP-A2- 2 151 913
- WO-A1-2017/081245

## Description

La présente invention revendique la priorité de la demande française 2112148 déposée le 17 novembre 2021.

La présente invention concerne le domaine des assemblages comportant une carte électronique en interface avec au moins deux autres éléments, et notamment le domaine des onduleurs, tels que les onduleurs adaptés à piloter le fonctionnement d'une machine électrique de traction d'un véhicule électrique ou hybride.

Un onduleur est, dans le domaine de l'électronique de puissance, un convertisseur de tension permettant de générer des tensions et des courants alternatifs à partir d'une source d'énergie électrique de tension ou de fréquence différente. Un onduleur permet notamment de générer les tensions alternatives adaptées au fonctionnement d'un moteur électrique, synchrone ou asynchrone, à partir d'une source de tension continue, telle qu'une batterie électrique.

Un onduleur polyphasé, par exemple triphasé, permet de hacher une tension continue en une tension sinusoïdale polyphasée (par exemple triphasée) équilibrée.

Les onduleurs comportent pour ce faire des modules de puissance comportant des interrupteurs électroniques, par exemple des IGBT (IGBT signifiant transistor bipolaire à grille isolée, de l'anglais « insulated Gate Bipolar Transistor »), dont les ouvertures et les fermetures sont commandées de manière appropriée.

Un tel onduleur comporte ainsi un assemblage de plusieurs composants : cartes électroniques (carte de contrôle et carte de puissance), un certain nombre de modules de puissance, des liaisons électriques sous la forme de barres d'interconnexion (généralement désignées par le terme anglophone « busbars ») généralement rassemblées en un système de busbar, et le cas échéant des capteurs, notamment des capteurs de courant. Dans le présent document, un « système de busbar » correspond à un composant comportant un ou plusieurs busbars.

Ces éléments sont généralement inclus dans un boîtier de protection également appelé carter.

Les différents composants mentionnés ci-dessus se trouvent ainsi en interface mécanique et/ou électronique les uns vis-à-vis des autres selon une configuration relativement complexe.

Chaque module de puissance est ainsi connecté d'une part au système de busbar, et d'autre part à la carte driver, via des broches soudées à celle-ci.

Les capteurs de courant sont liés à la carte de contrôle, et fonctionnent par effet Hall. Chaque capteur doit être positionné précisément dans l'ouverture d'un élément ferromagnétique en C positionné autour d'un busbar afin de mesurer le courant dans ce busbar.

Le montage d'un onduleur se révèle donc complexe, et nécessite d'employer des mesures afin d'assurer le bon positionnement et la bonne orientation des composants les uns par rapport aux autres.

Afin de simplifier la configuration de l'onduleur, de limiter la quantité de pièces et notamment de visserie à utiliser, et pour gagner en compacité, il est envisageable de rassembler les fonctions de la carte de contrôle et de la carte driver en une seule carte électronique, c'est-à-dire sur un seul PCB (de l'anglais « Printed Circuit Board » que l'on traduit généralement en français par « circuit imprimé »). L'utilisation d'une seule carte électronique au lieu de deux rend cependant encore plus complexe le positionnement des différents composants de l'onduleur entre eux. En effet, par exemple, un positionnement relatif très précis entre la carte électronique et les broches de commande des modules de puissance d'une part, et un positionnement relatif très précis entre la carte électronique (qui porte les capteurs de courant) et les busbars d'autre part, sont simultanément nécessaires.

Il existe dans l'état de la techniques certaines solutions générales qui ont été développées pour améliorer le positionnement relatif entre des composants électroniques.

Par exemple, le document EP3177123 propose de monter une carte électronique sur laquelle doivent être soudés de nombreux composants sur un support de carte électronique qui est doté d'orifices de guidage. Les orifices de guidage permettent de corriger, dans une certaine mesure, l'orientation des contacts mâles (broches) devant traverser la carte électronique et y être soudés.

Cette solution est cependant imparfaite en ce qu'elle est complexe, en ce que certes elle corrige le cas échéant l'orientation des contacts mâles mais elle ne garantit pas un positionnement relatif exact des composants vis-à-vis de la carte, et enfin en ce que le maintien en position obtenu est hyperstatique, ce qui doit dans la mesure du possible être évité.

Un onduleur selon l'état de la technique est divulgué dans le document EP2736160A1.

La présente invention vise à optimiser le positionnement relatif des composants d'un onduleur, en résolvant tout ou partie des problématiques indiquées ci-dessus.

Ainsi, l'invention porte sur un onduleur comportant :
- une carte électronique comportant un circuit imprimé ;
- un module de puissance comportant des connecteurs mâles introduits dans des connecteurs femelles de la carte électronique ;
- un guide de connecteurs configuré pour maintenir une orientation donnée entre les connecteurs mâles;
- un système de busbar, lié au module de puissance et comportant un élément ferromagnétique adapté à coopérer avec un capteur de courant ; et
- ledit capteur de courant, qui est lié rigidement à la carte électronique.

L'onduleur comporte deux éléments de centrage allongés s'étendant parallèlement et disposés à distance l'un de l'autre, et liés rigidement à une pièce de référence de l'onduleur.

Les deux éléments de centrage allongés traversent par des orifices calibrés la carte électronique, le guide de connecteur, et le système de busbar.

L'onduleur comportant en outre un carter, le carter ou une partie du carter forme la pièce de référence.

Cela permet de garantir un alignement souhaité entre la carte électronique, le guide de connecteurs, et le système de busbar.

L'alignement des trois composants que sont la carte électronique, le guide de connecteurs (et donc les connecteurs qu'il guide), et le système de busbar est ainsi obtenu de manière simple, à l'aide de deux éléments de centrage allongés. Cela permet l'utilisation d'une seule carte électronique rassemblant les fonctions communément réparties entre une carte de contrôle et une carte driver, tout en garantissant le bon alignement de celle-ci vis-à-vis de deux autres composants, à savoir le système de busbar et le guide de connecteurs. L'onduleur peut ainsi, par exemple, ne comporter qu'une seule carte électronique.

Par alignement, on entend plus particulièrement le centrage et le maintien en rotation des composants les uns par rapport aux autres. Les deux éléments de centrage allongés, parallèles et distants l'un de l'autre, assurent cette fonction d'alignement de manière isostatique.

Par orifice « calibré » il est entendu un orifice configuré, dans sa forme et ses dimensions, pour recevoir la goupille qui est avantageusement montée serrée dans l'orifice. La chaine de côte entre les éléments de centrage allongés et les pièces en interface avec les éléments de centrage allongés permet en particulier un positionnement précis des pièces vis-à-vis des éléments de centrage allongés, et donc des pièces entre elles.

En utilisant le carter comme pièce de référence, les éléments de centrage allongés permettent, en plus de l'alignement relatif entre la carte électronique, le système de busbar et le guide de connecteurs, de garantir un positionnement correct de ces éléments dans le carter de l'onduleur. D'autres moyens de positionnement dans le carter ne sont ainsi pas nécessaires.

Selon une configuration ici divulguée, qui n'est pas l'objet de la présente invention, les deux éléments de centrage allongés sont liés rigidement à l'un des composants parmi la carte électronique, le guide de connecteurs, et le système de busbar, le composant auquel les éléments de centrage allongés sont liés formant alors ladite pièce de référence, et les deux éléments de centrage allongés traversent par des orifices calibrés les deux autres composants parmi la carte électronique, le guide de connecteurs, et le système de busbar.

Le carter peut présenter une paroi intérieure formant au moins un logement, adapté à recevoir au moins un module de puissance de sorte à le pré-positionner dans l'onduleur lors de son montage.

Les éléments de centrage allongés peuvent être des goupilles.

Les goupilles sont des éléments allongés rectilignes rapportés, prismatiques ou cylindriques.

Les éléments de centrage allongés peuvent être des doigts de centrage formés de manière monobloc avec le carter.

Les doigts de centrage (qu'on peut également appeler doigts d'indexage) formés par le carter peuvent avoir diverses sections permettant d'assurer leur fonction de centrage : circulaire, en croix, etc. Les doigts de centrage peuvent être de section constante et présenter ainsi une forme cylindrique ou prismatique, ou être légèrement variable (par exemple les doigts de centrage peuvent être coniques).

L'onduleur comporte généralement plusieurs modules de puissance, avantageusement trois modules de puissance.

Il s'agit de l'architecture classique d'un onduleur permettant l'obtention d'un courant sinusoïdal triphasé, permettant par exemple l'alimentation d'une machine électrique de traction d'un véhicule automobile.

Le guide de connecteurs peut comporter des passages dans lesquels sont introduits les connecteurs mâles des modules de puissance afin de les maintenir selon l'orientation donnée souhaitée.

L'élément ferromagnétique peut être un noyau de section ouverte, par exemple en C, et le capteur de courant est positionné dans un entrefer du noyau. Il s'agit d'une configuration classique d'un capteur à effet Hall, qui nécessite un positionnement précis du capteur dans l'entrefer de l'élément ferromagnétique.

L'onduleur peut en outre comporter un écran interposé entre le ou les modules de puissance et la carte électronique, ledit écran comportant des orifices calibrés au travers desquels traversent les deux éléments de centrage allongés.

Les éléments de centrage allongés permettent alors d'aligner également l'écran vis-à-vis des autres composants de l'onduleur.

Les connecteurs mâles peuvent être des broches (généralement appelées « pins » selon la terminologie anglophone) et les connecteurs femelles peuvent être des trous de réception formés dans la carte électronique et permettant le soudage des broches. Le système de busbar peut comporter une ou plusieurs barres d'interconnexion en partie incluses dans un surmoulage en matériau plastique, ledit élément ferromagnétique étant inclus dans le surmoulage. Cette configuration permet un montage simple de l'onduleur et un haut niveau d'intégration, et est rendue possible grâce au très bon positionnement relatif entre les composant de l'onduleur qu'offre l'invention.

L'invention porte également sur un procédé d'assemblage d'un onduleur, ledit procédé comportant les étapes de :
- fourniture d'un carter comportant deux éléments de centrage allongés s'étendant parallèlement et disposés à distance l'un de l'autre, et liés rigidement audit carter ;
- montage d'un ensemble de busbar, les deux éléments de centrage allongés traversant deux orifices calibrés dudit ensemble de busbar, et fixation de l'ensemble de busbar sur le carter ;
- mise en place de modules de puissance dans le carter, lesdits modules de puissance comportant des connecteurs mâles ;
- montage d'un guide de connecteurs autour desdits connecteurs mâles pour maintenir entre eux une orientation donnée; lesdites deux éléments de centrage allongés traversant des orifices calibrés dudit guide de connecteurs ;
- montage d'une carte électronique, les deux éléments de centrage allongés traversant des orifices calibrés de ladite carte électronique, ce qui aligne ladite carte électronique vis-à-vis du guide de connecteurs et vis-à-vis de l'ensemble de busbar, de sorte que les connecteurs mâles des modules de puissance sont reçus dans des connecteurs femelles correspondants de la carte électronique et de sorte que des capteurs de courant liés rigidement à la carte électronique sont positionnés dans un entrefer d'un élément ferromagnétique du système de busbar.

D'autres particularités et avantages de l'invention apparaîtront encore dans la description ci-après.

Aux dessins annexés, donnés à titre d'exemples non limitatifs :
- la figure 1 représente, selon une vue partielle en trois dimensions, un onduleur conforme à un mode de réalisation de l'invention ;
- la figure 2 représente, selon une vue patielle en coupe, l'onduleur de la figure 1 ;
- la figure 3 présente, selon une vue tridimensionnelle en coupe, un aspect de la présente invention ;
- la figure 4 présente, selon une vue tridimensionnelle en coupe, un autre aspect de la présente invention ;
- les figures 5 à 9 représentent, selon des vues partielles en trois dimensions, différentes étapes de l'assemblagle de l'onduleur de la figure 1,
la figure 10 représente, selon une vue schématique partielle en trois dimensions, un carter d'onduleur pouvant être mis en œuvre dans un autre mode de réalisation de l'invention.

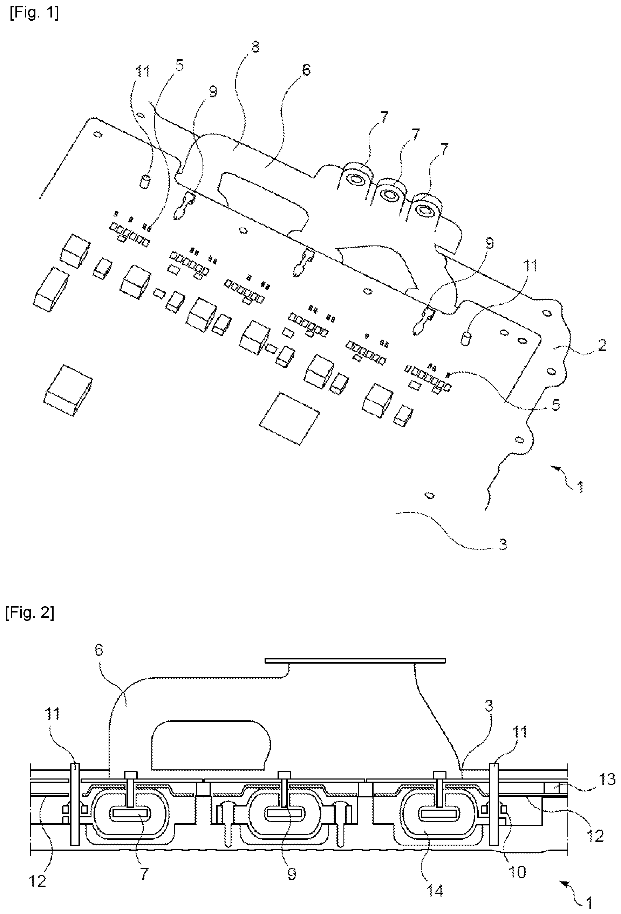

La figure 1 représente, selon une vue partielle en trois dimensions, un onduleur conforme à un mode de réalisation de l'invention. L'onduleur représenté est un onduleur adapté à alimenter et commander une machine électrique de traction d'un véhicule automobile.

L'onduleur 1 comporte un carter 2, adapté à recevoir les différents composants de l'onduleur 1. Le carter 2 est avantageusement réalisé en alliage d'aluminium, mais peut être formé de tout autre matériau approprié : acier, plastique, matériau plastique composite, etc.

A la figure 1, seule une partie inférieure du carter 2 est représentée. Une fois que les composants internes de l'onduleur sont assemblés, le carter est refermé par une partie supérieure formant couvercle, non représentée, afin d'assurer la protection des composants.

L'onduleur comporte une carte électronique 3. La carte électronique 3 réunit les fonctions de contrôle et de pilotage de l'onduleur 1. La carte électronique 3 comporte ou consiste en un circuit imprimé auquel sont liés divers composants électroniques et un ou plusieurs microprocesseurs ou microcontrôleurs.

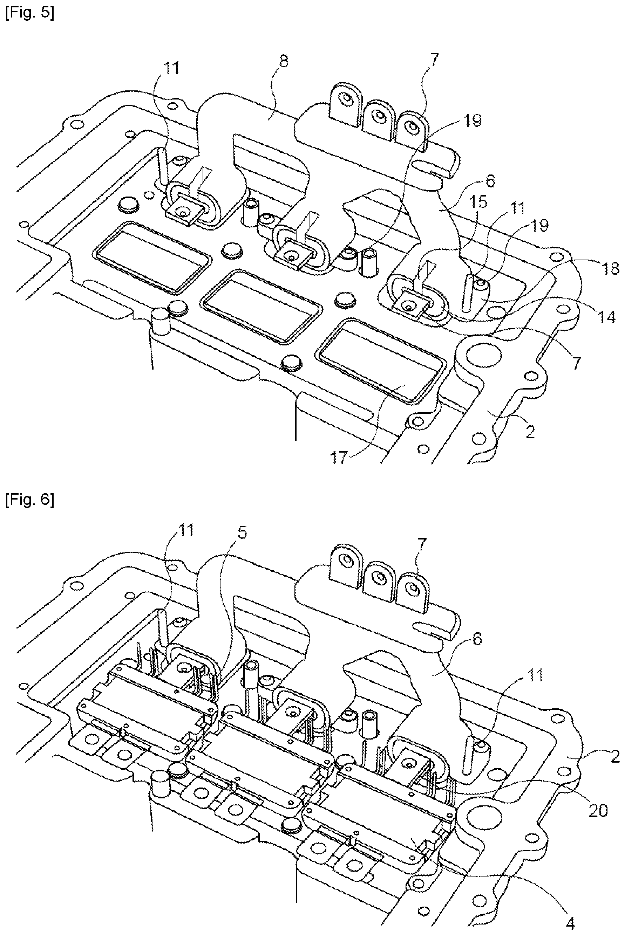

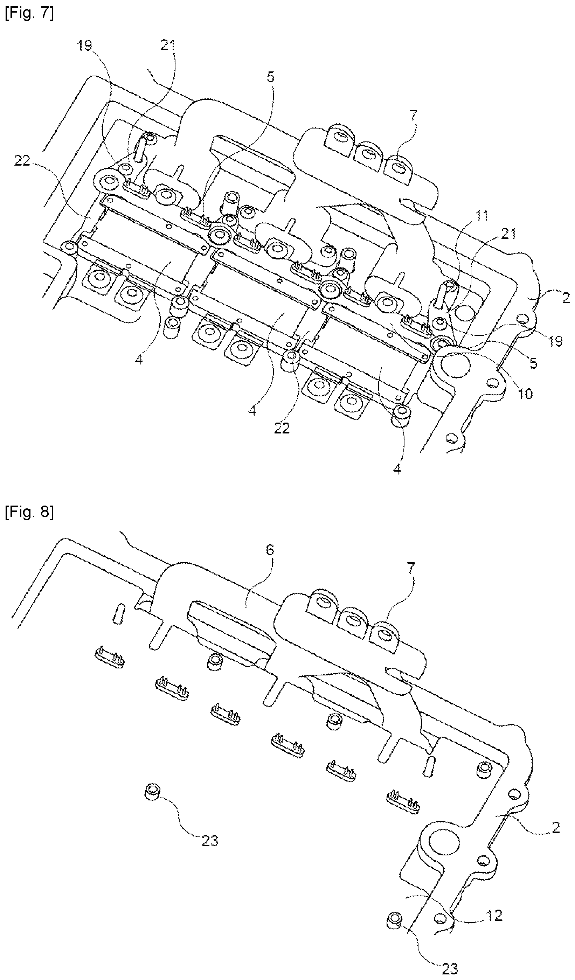

La carte électronique permet notamment le contrôle des modules de puissance 4 de l'onduleur (non visibles à la figure 1 car placés sous la carte électronique 3, mais visibles notamment aux figures 6 et 7 décrites ci-après). Chaque module de puissance comporte des connecteurs mâles 5, sous la forme de broches, qui sont soudés à la carte électronique 4. Les connecteurs mâles 5 traversent la carte électronique 3 via des trous adaptés à la réception desdits connecteurs mâles et y sont soudés.

L'onduleur comporte en outre un ensemble de busbar 6. L'ensemble de busbar comporte trois barres d'interconnexion 7 (ou busbars), qui sont incluses dans un surmoulage plastique 8.

Chaque barre d'interconnexion 7 est connectée à l'une de ses extrémités à un module de puissance. Cette liaison peut être réalisée par soudure ou vissage. Son autre extrémité, qui ressort du carter 2, est destinée à être liée à la machine électrique alimentée par l'onduleur, via une autre barre d'interconnexion ou une liaison conductrice souple.

Chaque barre d'interconnexion 7 est équipée d'un élément ferromagnétique permettant la mesure du courant circulant dans ladite barre d'interconnexion à l'aide d'un capteur de courant 9 porté par la carte électronique 3. Trois capteurs de courant 9 sont ainsi prévus dans le mode de réalisation représenté à la figure 1.

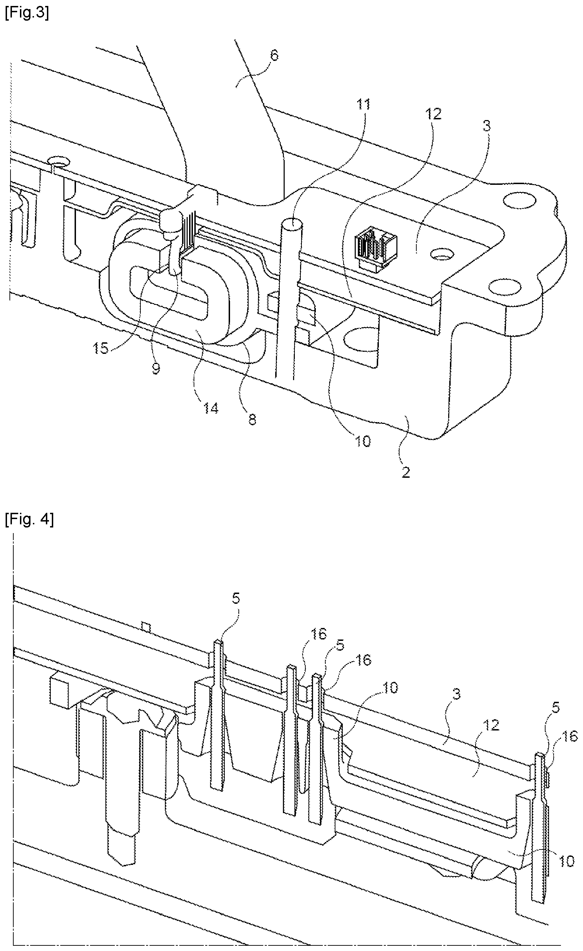

Chaque capteur de courant doit être positionné de manière précise par rapport à l'élément ferromagnétique équipant la barre d'interconnexion correspondante, comme expliqué plus en détail ci-après en référence à la figure 3.

Par ailleurs, tous les connecteurs mâles doivent être parfaitement positionnés vis-à-vis des connecteurs femelles de la carte électronique lors de l'assemblage de l'onduleur. Ce positionnement correct est d'autant plus complexe que lors de l'assemblage les modules de puissances ne sont pas visibles (car sous la carte électronique) et que les connecteurs mâles sont nombreux à aligner simultanément : dans l'exemple représenté, il y a sept connecteurs mâles 5 par module de puissance, soit vingt-et-un connecteurs mâles au total à aligner vis-à-vis de la carte électronique 3. Un guide de connecteurs 10 (visible aux figures 4 et 7) permet de maintenir l'orientation des connecteurs mâles 5 entre eux, mais il convient par ailleurs d'assurer l'alignement vis-à-vis de la carte électronique 3.

La présente invention propose d'assurer l'alignement entre la carte électronique et les connecteurs mâles des modules de puissance d'une part, et entre la carte électronique et l'ensemble de busbar d'autre part, à l'aide d'un système d'alignement simple fondé sur deux éléments de centrage allongés. Dans l'exemple du mode de réalisation illustré aux figures 1 à 9, les deux éléments de centrage allongés sont deux goupilles 11.

Les goupilles 11 sont des éléments droits allongés, avantageusement cylindriques, parallèles entre eux et à distance l'un de l'autre. Leur extrémité peut être biseautée ou arrondie pour faciliter l'insertion des composants à aligner.

La figure 2 présente plus en détail, selon une vue en coupe, l'agencement des goupilles 11 dans l'onduleur 1.

Les deux goupilles 11 sont liées au carter 2. Plus précisément, les goupilles 11 sont introduites dans des puits 12 formés dans le carter 2, en force ou avec un très faible jeu. Le carter 2 forme ainsi une pièce de référence par rapport à laquelle l'alignement des composants de l'onduleur est réalisé.

Chaque goupille 11 traverse l'ensemble busbar 6, le guide de connecteurs 10, et la carte électronique 3.

Chacun de ces composants comporte à cette fin deux orifices calibrés, ménagé dans le composant avec de faibles tolérances de position et de dimensions.

L'alignement relatif des trois composants précités est ainsi très précisément obtenu. Par ailleurs, cet alignement est réalisé de manière isostatique : il est en effet possible de considérer qu'une des deux goupilles 11 assure la fonction de centrage (positionnement relatif précis, hors orientation relative) tandis que l'autre goupille, grâce à son éloignement, assure l'orientation des composants.

Dans l'exemple représenté à la figure 2, l'onduleur comporte également un écran 12, qui est interposé entre les modules de puissance et la carte électronique 3. L'écran 12 peut être métallique (par exemple en acier ou en aluminium) et est maintenu à distance de la carte électronique 3 par des entretoises 13. L'alignement de l'écran est également obtenu à l'aide des deux goupilles 11, comme précédemment expliqué.

La figure 2 permet également de visualiser la configuration des capteurs de courant 9 et des éléments ferromagnétiques 14 correspondants. Cette configuration est visible également et plus précisément à la figure 3.

La figure 3 est une vue partielle, en coupe et en trois dimensions de l'onduleur 1. La coupe est réalisée dans le plan matérialisé par les deux goupilles 11. Pour plus de lisibilité, la goupille 11, le capteur de courant 9 et l'élément ferromagnétique 14 représentés sur la figure 3 ne sont pas coupés. L'élément ferromagnétique a une configuration en « C » (de sorte que ce type d'élément ferromagnétique est communément appelé par l'expression anglophone « C-core »).

D'autres configurations d'éléments ferromagnétiques sont envisageables. L'élément ferromagnétique peut avoir diverses sections ouvertes ménageant un entrefer, par exemple en U ou en Ω (Omega).

L'élément ferromagnétique 14 comporte ainsi une ouverture, ou entrefer 15, dans lequel le capteur de courant 9 doit être positionné avec précision.

L'élément ferromagnétique 14 entoure une barre d'interconnexion 7. Il est avantageusement inclus dans l'ensemble busbar 6, en étant par exemple intégré dans le surmoulage plastique 8.

La figure 3 illustre ainsi la complexité du positionnement relatif très précis qui doit être réalisé entre le capteur de courant 9 (et donc la carte électronique 3 à laquelle il est relié) et l'élément ferromagnétique 14 correspondant (et donc l'ensemble busbar auquel il est intégré).

La figure 4 représente, selon une autre vue partielle, en coupe et en trois dimensions de l'onduleur 1, la problématique de l'alignement des connecteurs mâles 5 des modules de puissance. La coupe de la figure 4 est réalisée dans un plan parallèle au plan matérialisé par les deux goupilles 11, et passant par les connecteurs mâles 5. Chaque module de puissance comporte en effet plusieurs connecteurs mâles 5 destinés au contrôle du module de puissance. Ces connecteurs peuvent se présenter sous la forme de broches, comme dans l'exemple représenté, et avoir ainsi une grande longueur ce qui rend leur orientation relative assez incertaine. Afin de garantir le positionnement relatif et l'orientation relative des connecteurs mâles 5 entre eux, on utilise un guide de connecteurs 10. Le guide de connecteurs est une pièce, par exemple en plastique, qui présente des passages dans lesquels sont introduits les connecteurs mâles des modules de puissances afin de les maintenir selon l'orientation donnée souhaitée. Les passages peuvent présenter une portion conique, de sorte à permettre une légère correction de l'orientation et du positionnement des broches entre elles lors de la mise en place du guide de connecteurs 10 autour des broches.

Les broches, ou plus généralement les connecteurs mâles 5, doivent être en outre parfaitement alignés par rapport aux connecteurs femelles 16 de la carte électronique 3. Les connecteurs femelles 16 sont dans l'exemple représenté des trous permettant aux broches de traverser la carte électronique 3 et de les y souder.

Les figures 5 à 9 présentent différentes étapes de l'assemblage de l'onduleur de la figure 1.

A la figure 5, la partie inférieure du carter 2 est représentée. Les deux goupilles 11 sont assemblées au carter 2, prête à recevoir l'empilement des composants de l'onduleur en assurant leur alignement.

Le carter 2 ici représenté a la particularité de présenter des logements 17, chaque logement 17 étant destiné à recevoir un module de puissance.

Dans la première étape de l'assemblage représentée à la figure 5, l'ensemble de busbar 6 est positionné dans le carter 2. Pour cela les goupilles 11 sont introduites dans des orifices calibrés de l'ensemble de busbar 6, par exemple positionnées sur les pattes latérales 18 de l'ensemble de busbar 6 formées par le surmoulage plastique 8. Une fois aligné à l'aide des goupilles 11, l'ensemble de busbar est fixé au carter, par exemple par des vis 19.

Dans l'étape suivante représentée à la figure 6, les trois modules de puissance de l'onduleur sont rapportés dans le carter.

Une certaine correspondance de forme entre chaque logement 17 et une partie du module de puissance qui y est placé permet un pré-positionnement de ce dernier. Chaque module de puissance 4 est ainsi pré-positionné notamment de sorte que sa sortie 20 soit correctement positionnée par rapport à la barre d'interconnexion 7 à laquelle elle sera reliée.

Dans l'étape suivante représentée à la figure 7, un guide de connecteurs 10 est mis en place, sur et autour des connecteurs mâles 5. Le guide de connecteurs est avant tout mis en position sur les goupilles 11.

Pour cela les goupilles 11 sont introduites dans des orifices calibrés formés dans le guide de connecteurs 10. Le guide de connecteurs 10, dont la partie fonctionnelle est située dans un plan distinct de celui matérialisé par les goupilles 11, comporte deux bras 21 dans lesquels sont formés les orifices calibrés destinés à recevoir les goupilles 11.

Une fois le guide de connecteurs 10 en position, ce qui garantit le bon alignement de tous les connecteurs mâles 5 des modules de puissance 4, il peut être fixé au carter (et/ou le cas échéant à l'ensemble de busbar lui-même fixé au carter), par exemple avec des vis 19.

Les modules de puissance peuvent alors être reliés aux barres d'interconnexion 7 et fixés dans le carter 2 à l'aide de brides 22 (ou autre moyen de fixation approprié).

La figure 8 représente la mise en position de l'écran 12 au-dessus des modules de puissance. L'écran 12 est aligné par l'introduction des goupilles 11 dans des orifices calibrés qu'il comporte. On notera cependant que les tolérances appliquées à ces orifices de l'écran 12 peuvent être plus grandes que pour les autres composants, car l'alignement de l'écran n'a pas besoin d'être aussi précis que l'alignement relatif de l'ensemble de busbar, du guide de connecteurs et de la carte électronique. Des entretoises 23 sont prévues sur l'écran 12.

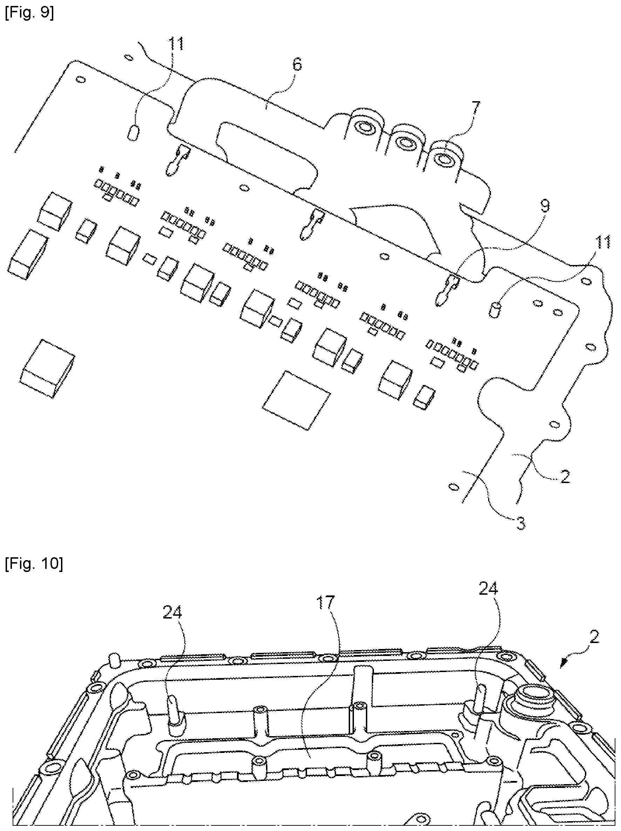

La figure 9 représente l'étape de montage de la carte électronique 3 de l'onduleur. La carte électronique 3 est alignée vis-à-vis des autres composants par introduction des deux goupilles 11 dans des orifices calibrés qu'elle comporte.

La carte électronique est mise au contact des entretoises 23 qui permettent de maintenir la distance souhaitée entre la carte électronique 3 et l'écran 12. La carte électronique 3 est ensuite fixée, par exemple par des vis, au carter 2. Les vis de fixation peuvent traverser les entretoises 23 et l'écran 12 pour être directement en prise dans le carter 2.

Lors de la mise en place de la carte électronique 3, grâce au guidage procuré par les goupilles 11, la carte électronique 3 est correctement alignée à la fois vis-à-vis des connecteurs mâles 5, puisque le guide de connecteurs 5 est indexé en position par les goupilles 11, et vis-à-vis de l'entrefer 15 des éléments ferromagnétiques 14, puisque l'ensemble de busbar 6 est aussi indexé en position par les goupilles 11.

Cela permet un montage de la carte correct et sans risque. Il est en effet certain que les connecteurs mâles 5 pénètrent précisément les connecteurs femelles 16 de la carte lors de sa mise en place et sa descente le long des goupilles 11, dans le carter 2. Il est par ailleurs certain que les capteurs de courant sont correctement positionnés vis-à-vis de l'élément ferromagnétique 14, c'est-à-dire dans son entrefer 15 dans l'exemple représenté.

L'ensemble des composants de l'onduleur est ainsi assemblé, et le carter 2 peut être fermé.

Bien que décrite en référence à un mode de réalisation particulier représenté sur les figures décrites ci-dessus, l'invention n'est bien évidemment pas limitée à ce seul mode de réalisation.

Le mode de réalisation représenté aux figures décrites ci-dessus utilise le carter comme pièce de référence à laquelle les deux goupilles 11 sont fixées.

Le mode de réalisation représenté présente l'avantage de ne pas nécessiter de moyen supplémentaire pour assurer le bon positionnement de ces trois composants dans le carter de l'onduleur.

La figure 10 illustre un autre mode de réalisation de la présente invention. Plus précisément, la figure 10 représente un carter 2 d'onduleur pouvant être mis en œuvre dans un autre mode de réalisation de l'invention.

Tout comme le carter 2 utilisé dans le mode de réalisation représenté aux figures 1 à 9, le carter 2 de la figure 10 est avantageusement réalisé en alliage d'aluminium, mais peut être alternativement formé de tout autre matériau approprié. En l'occurrence, seule la partie inférieure du carter 2 est représentée à la figure 10.

Cette partie inférieure comporte un logement 17 adapté à recevoir et pré-positionner des modules de puissance, en l'occurrence trois modules de puissance dans cet exemple.

Le carter 2 forme dans ce mode de réalisation la pièce de référence par rapport à laquelle l'alignement des composants de l'onduleur est réalisé. Néanmoins, au lieu d'utiliser des goupilles rapportées, deux doigts de centrage 24 sont directement formés par le carter 2, c'est-à-dire qu'ils sont monoblocs avec le carter.

Les doigts de centrage 24 peuvent en particulier être usinés dans la masse du carter. Tout comme les goupilles 11 du mode de réalisation décrit précédemment en référence aux figures 1 à 9, les doigts de centrage 24 sont des éléments rigides allongés, qui sont situés à distance l'un de l'autre et qui s'étendent parallèlement entre eux. Ils présentent une section constante, ce qui leur confère une forme générale cylindrique ou prismatique. Leur extrémité peut néanmoins être biseautée ou arrondie pour faciliter l'insertion des composants à aligner.

La formation de doigts de centrage directement issus de matière avec le reste du carter 2 présente plusieurs avantages. La chaîne de côte pour l'alignement des composants est simplifiée, car un « maillon » de cette chaine est supprimé comparativement à la solution utilisant des goupilles rapportées. Il en résulte moins de dispersions et plus de précision. Alternativement, une tolérance légèrement supérieure peut être appliquée dans la formation des doigts de centrage tout en garantissant la précision d'alignement souhaitée. De manière générale, une précision plus grande peut être obtenue car les doigts de centrage sont solidaires du carter. L'usinage des doigts de centrage 24 et l'usinage du reste du carter 2 sont réalisés dans un même référentiel.

Enfin, cette solution supprime une opération de montage, dans la mesure où les éléments de centrage, à savoir les doigts de centrage, n'ont pas à être mis en place lors de l'assemblage car ils sont déjà présents, formés par le carter.

L'invention ainsi développée permet d'obtenir de manière simple un alignement correct entre trois composants ou plus d'un onduleur. Cela permet de réunir sur une seule carte électronique des fonctions, qui nécessitent un positionnement physique de la carte précis vis-à-vis d'autres composants de l'onduleur, généralement gérées par plusieurs cartes. Cela permet également un montage fiable et sûr de la carte « en aveugle », c'est-à-dire sans pouvoir contrôler visuellement, lors du montage de la carte dans l'onduleur, son bon alignement des éléments avec lesquels elle est en interaction.

## Revendications

1. Onduleur comportant :
- un carter ;
- une carte électronique (3) ;
- un module de puissance (4) comportant des connecteurs mâles (5) introduits dans des connecteurs femelles (16) de la carte électronique (3) ;
- un guide de connecteurs (10) configuré pour maintenir une orientation donnée entre lesdits connecteurs mâles (5);
- un système de busbar (6), lié au module de puissance (4) et comportant un élément ferromagnétique (14) adapté à coopérer avec un capteur de courant (9) ;
- ledit capteur de courant (9), qui est lié rigidement à la carte électronique (3),
dans lequel l'onduleur (1) comporte deux éléments de centrage allongés s'étendant parallèlement et disposés à distance l'un de l'autre, et liés rigidement à une pièce de référence de l'onduleur,
et dans lequel les deux éléments de centrage allongés traversent par des orifices calibrés la carte électronique (3), le guide de connecteurs (10), et le système de busbar (6) de sorte à garantir un alignement souhaité entre la carte électronique (3), le guide de connecteurs (10), et le système de busbar (6),
**caractérisé en ce que** le carter (2) ou une partie du carter (2) forme la pièce de référence.

2. Onduleur selon la revendication 1 dans lequel le carter (2) présente une paroi intérieure formant au moins un logement, adapté à recevoir au moins un module de puissance (4) de sorte à le pré-positionner dans l'onduleur lors de son montage.

3. Onduleur selon la revendication 1 ou la revendication 2, dans lequel les éléments de centrage allongés sont des goupilles (11).

4. Onduleur selon l'une des revendications précédentes, dans lequel les éléments de centrage allongés sont des doigts de centrage formés de manière monobloc avec le carter (2).

5. Onduleur selon l'une des revendications précédentes comportant plusieurs modules de puissance (4), avantageusement trois modules de puissance (4).

6. Onduleur selon la revendication 5, dans lequel le guide de connecteurs (10) comporte des passages dans lesquels sont introduits les connecteurs mâles (5) des modules de puissance (4) afin de les maintenir selon l'orientation donnée souhaitée.

7. Onduleur selon l'une des revendications précédentes dans lequel l'élément ferromagnétique (14) est un noyau de section ouverte, par exemple en C, et le capteur de courant (9) est positionné dans un entrefer du noyau.

8. Onduleur selon l'une des revendications précédentes, comportant en outre un écran (12) interposé entre le ou les modules de puissance (4) et la carte électronique (3), ledit écran comportant des orifices calibrés au travers desquels traversent les deux éléments de centrage allongés.

9. Onduleur selon l'une des revendications précédentes, dans lequel les connecteurs mâles (5) sont des broches et les connecteurs femelles (16) sont des trous de réception formés dans la carte électronique (3) et permettant le soudage des broches.

10. Onduleur selon l'une des revendications précédentes dans lequel le système de busbar (6) comporte une ou plusieurs barres d'interconnexion (7) en partie incluses dans un surmoulage plastique (8), ledit élément ferromagnétique (14) étant inclus dans le surmoulage.

11. Procédé d'assemblage d'un onduleur, ledit procédé comportant les étapes de :
- fourniture d'un carter (2) comportant deux éléments de centrage allongés s'étendant parallèlement et disposés à distance l'un de l'autre, et liés rigidement audit carter (2) ;
- montage d'un ensemble de busbar, les deux éléments de centrage allongés traversant deux orifices calibrés dudit ensemble de busbar, et fixation de l'ensemble de busbar sur le carter (2) ;
- mise en place de modules de puissance (4) dans le carter (2), lesdits modules de puissance (4) comportant des connecteurs mâles (5) ;
- montage d'un guide de connecteurs (10) autour desdits connecteurs mâles (5) pour maintenir entre eux une orientation donnée; lesdites deux éléments de centrage allongés traversant des orifices calibrés dudit guide de connecteurs,
- montage d'une carte électronique (3), les deux éléments de centrage allongés traversant des orifices calibrés de ladite carte électronique (3), ce qui aligne ladite carte électronique (3) vis-à-vis du guide de connecteurs (10) et vis-à-vis de l'ensemble de busbar, de sorte que les connecteurs mâles (5) des modules de puissance (4) sont reçus dans des connecteurs femelles (16) correspondants de la carte électronique (3) et de sorte que des capteurs de courant liés rigidement à la carte électronique (3) sont positionnés dans un entrefer d'un élément ferromagnétique (14) du système de busbar (6).

## Patentansprüche

1. Wechselrichter mit:
- einem Gehäuse;
- einer elektronischen Karte (3);
- einem Leistungsmodul (4) mit Steckverbindern (5), die in Steckverbindern (16) der elektronischen Karte (3) eingeführt sind;
- einer Steckerführung (10), die so konfiguriert ist, dass sie eine bestimmte Orientierung zwischen den Steckverbindern (5) aufrechterhält;
- einem mit dem Modul verbundenen Düsensystem (6) Leistungssensor (4) mit einem ferromagnetischen Element (14), das mit einem Stromsensor (9) zusammenwirkt;
- wobei der Stromsensor (9) fest mit der elektronischen Karte (3) verbunden ist,
wobei der Wechselrichter (1) zwei längliche Zentrierelemente aufweist, die sich parallel erstrecken und im Abstand voneinander angeordnet sind und starr mit einem Referenzteil des Wechselrichters verbunden sind Dueller,
und bei dem die beiden länglichen Zentrierelemente durch kalibrierte Öffnungen die elektronische Karte (3), die Verbinderführung (10) und das Düsensystem (6) derart ausbreiten, dass eine gewünschte Ausrichtung zwischen der elektronischen Karte (3), der Verbinderführung (10) und dem Düsensystem (6) gewährleistet ist,
Das Gehäuse (2) oder ein Teil des Gehäuses (2) bildet das Referenzteil.

2. Wechselrichter nach Anspruch 1, bei dem das Gehäuse (2) eine innere Wand aufweist, die mindestens ein Gehäuse bildet, das dazu ausgelegt ist, mindestens ein Leistungsmodul (4) aufzunehmen, um es bei seiner Montage in dem Wechselrichter vorzupositionieren.

3. Wechselrichter nach Anspruch 1 oder Anspruch 2, wobei die länglichen Zentrierelemente Stifte (11) sind.

4. Wechselrichter nach einem der vorhergehenden Ansprüche, bei dem die länglichen Zentrierelemente Zentrierfinger sind, die einstückig mit dem Gehäuse (2) ausgebildet sind.

5. Wechselrichter nach einem der vorhergehenden Ansprüche mit mehreren Leistungsmodulen (4), vorzugsweise drei Leistungsmodulen (4).

6. Wechselrichter nach Anspruch 5, wobei die Verbinderführung (10) Durchgänge aufweist, in die die männlichen Verbinder (5) der Leistungsmodule (4) eingeführt sind, um sie in der gewünschten gegebenen Orientierung zu halten.

7. Wechselrichter nach einem der vorhergehenden Ansprüche, bei dem das ferromagnetische Element (14) ein Kern mit offenem Querschnitt, z.B. in C, ist und der Stromsensor (9) in einem Spalt des Kerns angeordnet ist.

8. Wechselrichter nach einem der vorhergehenden Ansprüche, ferner mit einem Schirm (12), der zwischen dem oder den Leistungsmodulen (4) und der elektronischen Karte (3) angeordnet ist, wobei der Schirm kalibrierte Öffnungen aufweist, durch die die beiden länglichen Zentrierelemente hindurchgehen.

9. Wechselrichter nach einem der vorhergehenden Ansprüche, bei dem die Steckerstifte (5) Stifte sind und die Steckerstifte (16) Aufnahmelöcher sind, die in der elektronischen Karte (3) ausgebildet sind und das Schweißen der Stifte ermöglichen.

10. Wechselrichter nach einem der vorhergehenden Ansprüche, bei dem das Düsensystem (6) einen oder mehrere Verbindungsstangen (7) aufweist, die teilweise in einem Kunststoffumformteil (8) enthalten sind, wobei das ferromagnetische Element (14) in dem Umformteil enthalten ist.

11. Verfahren zum Montieren eines Wechselrichters, wobei das Verfahren die Schritte umfasst:
- Bereitstellen eines Gehäuses (2) mit zwei länglichen Zentrierelementen, die sich parallel erstrecken und in einem Abstand voneinander angeordnet sind und fest mit dem Gehäuse (2) verbunden sind;
- Montieren einer Düsenanordnung, wobei die beiden länglichen Zentrierelemente durch zwei kalibrierte Öffnungen der Düsenanordnung verlaufen und Befestigen der Düsenanordnung Am Gehäuse (2);
- Anbringen von Leistungsmodulen (4) im Gehäuse (2), wobei die Leistungsmodule (4) Stecker (5) aufweisen;
- Anbringen einer Steckerführung (10) um die Stecker (5) herum, um eine bestimmte Ausrichtung dazwischen aufrechtzuerhalten; Die beiden länglichen Zentrierelemente, die durch kalibrierte Öffnungen der Verbinderführung hindurchgehen,
- Montage einer elektronischen Karte (3), wobei die beiden länglichen Zentrierelemente kalibrierte Öffnungen der elektronischen Karte (3) ausgiessen, wodurch die elektronische Karte (3) der Verbinderführung (10) und der Düsenanordnung zugewandt wird, sodass die Steckverbindungen die Stecker (1) 5) Leistungsmodule (4) werden in entsprechenden Steckverbindern (16) der Elektronikkarte (3) aufgenommen, sodass starr mit der Elektronikkarte (3) verbundene Stromsensoren in einem Luftspalt eines ferromagnetischen Elements (14) des Düsensystems (6) positioniert sind.

## Claims

1. inverter containing:
- a crankcase;
- an electronic card (3);
- a power module (4) containing male connectors (5) inserted into female connectors (16) of the electronic card (3);
- a connector guide (10) configured to maintain a given orientation between male connectors (5);
- a busbar system (6), linked to the power module (5) 4) and having a ferromagnetic element (14) suitable for co-operation with a current sensor (9);
- said current sensor (9), which is rigidly linked to the electronic card (3),
in which the inverter (1) has two elongated balance elements extending parallel and arranged remotely from each other, and rigidly linked to a reference part of the undulation their,
and in which the two centering elements lengthen through calibrated orifices the electronic card (3), the connector guide (10), and the busbar system (6) so as to ensure a desired alignment between the electronic card (3), the connector guide (10), and the busbar system (6),
**characterized in that** the case (2) or part of the case (2) forms the reference part.

2. inverter according to claim 1 in which the case (2) has an inner wall forming at least one housing, suitable for receiving at least one power module (4) so that it can be pre-positioned in the inverter when it is assembled.

3. inverter according to Claim 1 or Claim 2, in which elongated centering elements are pins (11).

4. inverter according to one of the previous claims, in which elongated centering elements are centering fingers formed monobloc with the crankcase (2).

5. inverter according to one of the previous claims with several power modules (4), advantageous three power modules (4).

6. inverter according to Claim 5, in which the connector guide (10) contains passages in which male connectors (5) of power modules (4) are introduced to maintain them according to the desired given orientation.

7. inverter according to one of the previous claims in which the ferromagnetic element (14) is an open section core, e.g. in C, and the current sensor (9) is positioned in a core spacer.

8. inverter according to one of the previous claims, which also includes a screen (12) between the power module(s) (4) and the electronic card (3), the said screen having calibrated holes through which the two elongated center elements cross.

9. inverter according to one of the previous claims, in which male connectors (5) are pins and female connectors (16) are receiving holes formed in the electronic card (3) and allowing the welding of pins.

10. inverter according to one of the previous claims in which the busbar system (6) has one or more interconnection bars (7) partially included in a plastic overcast (8), the said ferromagnetic element (14) being included in the overcast.

11. Assembly process of an inverter, the process consisting of the steps of:
- supply of a case (2) with two elongated centering elements extending parallel and arranged remotely from each other, and rigidly linked to that case (2);
- assembly of a busbar set, the two elongated centering elements crossing two calibrated orifices of the said busbar set, and fixation of the set of busbar on the crankcase (2);
- installation of power modules (4) in the crankcase (2), said power modules (4) with male connectors (5);
- installation of a connector guide (10) around the said male connectors (5) to maintain a given orientation between them; the two elongated centering elements passing through calibrated orifices of the said connector guide,
- mounting of an electronic card (3), the two elongated centering elements straining calibrated orifices of the said electronic card (3), thus aligning the said electronic card (3) with the connector guide (10) and with the busbar set, male connectors (5) of power modules (4) are received in corresponding female connectors (16) of the electronic card (3) and so that current sensors rigidly linked to the electronic card (3) are positioned in a spacer of a ferromagnetic element (14) of the busbar system (6).
